# EUROPEAN PATENT APPLICATION

(11) **EP 4 729 332 A1**
(43) Date of publication of application: **22.04.2026**
(21) Application number: 25207609.6
(22) Date of filing: 08.10.2025
(51) Int. Cl.: B60L 3/00, B60L 3/04, B60L 53/10, B60L 53/14, B60L 53/62, G01R 31/14, G01R 27/18

(54) **VEHICLE, CHARGING SYSTEM, AND METHOD OF CHARGING VEHICLE**

(30) Priority: 18.10.2024 JP 2024184057
(71) Applicant: TOYOTA JIDOSHA KABUSHIKI KAISHA, Toyota-shi, Aichi-ken 471-8571 (JP)
(72) Inventor: MOTOHIRA, Akito, TOYOTA-SHI, AICHI-KEN, 471-8571 (JP); HARA, Kugo, TOKYO, 150-8554 (JP)
(74) Representative: Cabinet Beau de Loménie

(57) **Abstract**

A vehicle (1) includes a battery pack (15) configured to be charged with charging power which is DC power from a charger (2), a voltage sensor (13) that detects a charging voltage of charging power, a switching device (14) configured to switch between charging schemes different in charging voltage, and a vehicle controller (16) that determines a charging scheme. The vehicle controller (16) obtains from the voltage sensor (13), an insulation diagnosis voltage (Vdiag) applied by the charger (2) and determines the charging scheme based on the insulation diagnosis voltage (Vdiag).

## Description

### CROSS REFERENCE TO RELATED APPLICATIONS

This nonprovisional application is based on Japanese Patent Application No. 2024-184057 filed with the Japan Patent Office on October 18, 2024, the entire contents of which are hereby incorporated by reference and to which the person of the art can refer when considering the present disclosure.

### BACKGROUND

### Field

The present disclosure relates to a vehicle, a charging system, and a method of charging a vehicle.

### Description of the Background Art

Japanese Patent No. 7110159 discloses a power supply system mounted on a vehicle. The power supply system includes a first battery, a second battery, and a switching unit. The switching unit is capable of switching between a series circuit in which the first battery and the second battery are connected in series and a parallel circuit in which the first battery and the second battery are connected in parallel.

### SUMMARY

Some of vehicles capable of what is called external charging with electric power supplied from a charger provided outside the vehicles are configured to switch between charging schemes different from each other in charging voltage for reduction in charging time period. By way of example, a vehicle is configured to switch between a high-voltage (for example, 400 V) charging scheme and an ultra-high voltage (for example, 800 V) charging scheme.

In connection with such vehicles, the present inventors have found that a problem as below may arise. In general, in external charging, prior to actual power feed/charging, a plurality of messages are exchanged between a vehicle and a charger. The plurality of messages include a message indicating a maximum output voltage of the charger, the message being transmitted from the charger to the vehicle. The vehicle may receive the message from the charger and determines the charging scheme thereof in accordance with the maximum output voltage of the charger.

When a vehicle changes the charging scheme after transmission of the message, however, some of chargers quit a communication sequence in normal operations and do not feed power to the vehicle. In order to more reliably perform external charging of the vehicle, the vehicle may desirably determine the charging scheme of the vehicle itself before it receives from the charger, the message that can be used for determination of the charging scheme.

The present disclosure was made to solve the problem above, and one of objects of the present disclosure is determination by a vehicle, of a charging scheme of the vehicle itself before the vehicle receives from the charger, a message that can be used for determination of the charging scheme of the vehicle.

A vehicle according to a first aspect of the present disclosure is configured to externally be charged with DC power supplied from a charger through a charging cable. The vehicle includes a power storage device configured to be charged with charging power which is the DC power from the charger, a voltage sensor that detects a charging voltage of the charging power, a switching device configured to switch between charging schemes different in charging voltage, and a controller that determines a charging scheme. The controller obtains from the voltage sensor, an insulation diagnosis voltage applied by the charger and determines the charging scheme based on the insulation diagnosis voltage.

A charging system according to a second aspect of the present disclosure includes a charger and a vehicle configured to externally be charged with DC power supplied from a charger through a charging cable. The vehicle includes a power storage device configured to be charged with charging power which is the DC power from the charger, a voltage sensor that detects a charging voltage of the charging power, a switching device configured to switch between charging schemes different in charging voltage, and a controller that determines a charging scheme. The charger conducts insulation diagnosis of the charger when the vehicle and the charger are connected to each other through the charging cable, and after the charger conducts the insulation diagnosis, the charger transmits a message indicating a maximum output voltage of the charger to the controller. The controller obtains from the voltage sensor, an insulation diagnosis voltage applied by the charger while the charger conducts the insulation diagnosis and determines the charging scheme based on the insulation diagnosis voltage.

A method of charging a vehicle according to a third aspect of the present disclosure is a method of externally charging the vehicle with charging power which is DC power supplied from a charger through a charging cable. The vehicle is configured to switch between charging schemes different in charging voltage of the charging power. The method includes conducting, by the charger, insulation diagnosis of the charger when the vehicle and the charger are connected to each other through the charging cable, obtaining, by the vehicle, an insulation diagnosis voltage applied by the charger with a voltage sensor in the conducting insulation diagnosis, determining, by the vehicle, a charging scheme based on the insulation diagnosis voltage, and transmitting a message indicating a maximum output voltage of the charger from the charger to the vehicle after the determining the charging scheme.

In the configuration and the method, the vehicle (controller) obtains the insulation diagnosis voltage applied by the charger from the voltage sensor and determines the charging scheme based on the insulation diagnosis voltage. Therefore, the vehicle can determine the charging scheme of the vehicle itself before it receives the message from the charger.

The foregoing and other objects, features, aspects, and advantages of the present disclosure will become more apparent from the following detailed description of the present disclosure when taken in conjunction with the accompanying drawings.

### BRIEF DESCRIPTION OF THE DRAWINGS

Fig. 1 is a schematic diagram showing an overall configuration of a charging system according to the present embodiment.
Fig. 2 is a circuit block diagram showing in detail an exemplary configuration of the charging system.
Fig. 3 is a circuit block diagram showing in detail an exemplary configuration of a switching device and a battery pack.
Fig. 4 is a diagram for illustrating control of the switching device for realizing a high voltage scheme.
Fig. 5 is a diagram for illustrating control of the switching device for realizing an ultra-high voltage scheme.
Fig. 6 is a sequence diagram showing an exemplary communication sequence in external charging.
Fig. 7 is a flowchart showing an exemplary processing procedure for determining a charging scheme in the present embodiment.
Fig. 8 is a conceptual diagram for illustrating insulation diagnosis in the present embodiment.
Fig. 9 is a diagram for illustrating a technique to set a highest allowable voltage in a comparative example.
Fig. 10 is a diagram for illustrating a technique to set a highest allowable voltage in the present modification.

### DESCRIPTION OF THE PREFERRED EMBODIMENTS

An embodiment of the present disclosure will be described in detail below with reference to the drawings. The same or corresponding elements in the drawings have the same reference characters allotted and description thereof will not be repeated.

### [Embodiment]

### <Overall Configuration of Charging System>

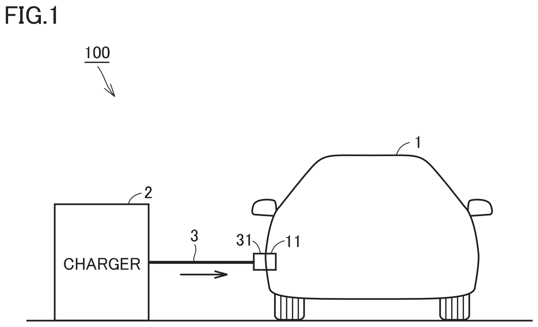

Fig. 1 is a schematic diagram showing an overall configuration of a charging system according to the present embodiment. A charging system 100 includes a vehicle 1, a charger 2, and a charging cable 3. Fig. 1 shows a situation in which vehicle 1 and charger 2 are connected to each other with a vehicle plug 31 and a vehicle socket 11 being interposed and external charging from charger 2 to vehicle 1 is performed.

Vehicle 1 is, for example, a battery electric vehicle (BEV). Vehicle 1 may be any vehicle configured to be capable of external charging, such as a plug-in hybrid electric vehicle (PHEV).

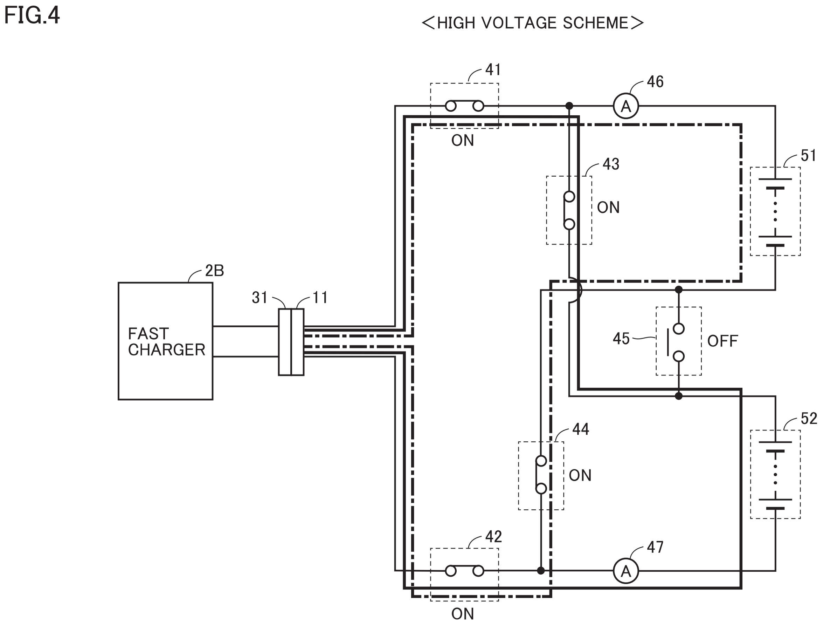

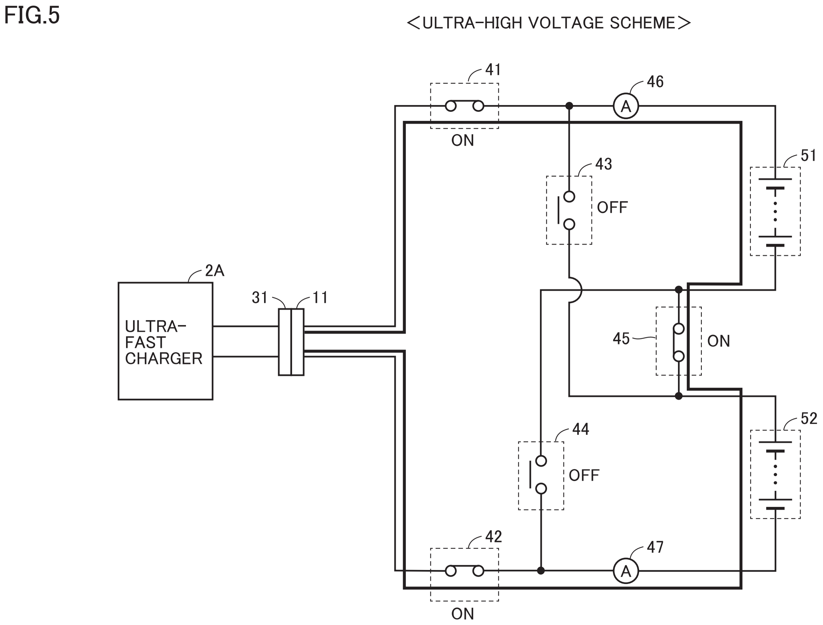

Charger 2 is, for example, a direct-current (DC) charger that supplies DC power. Charger 2 may be a fast charger 2B (see Fig. 4) provided at a public charging stand (which is also called a charging station) or an ultra-fast charger 2A (see Fig. 5).

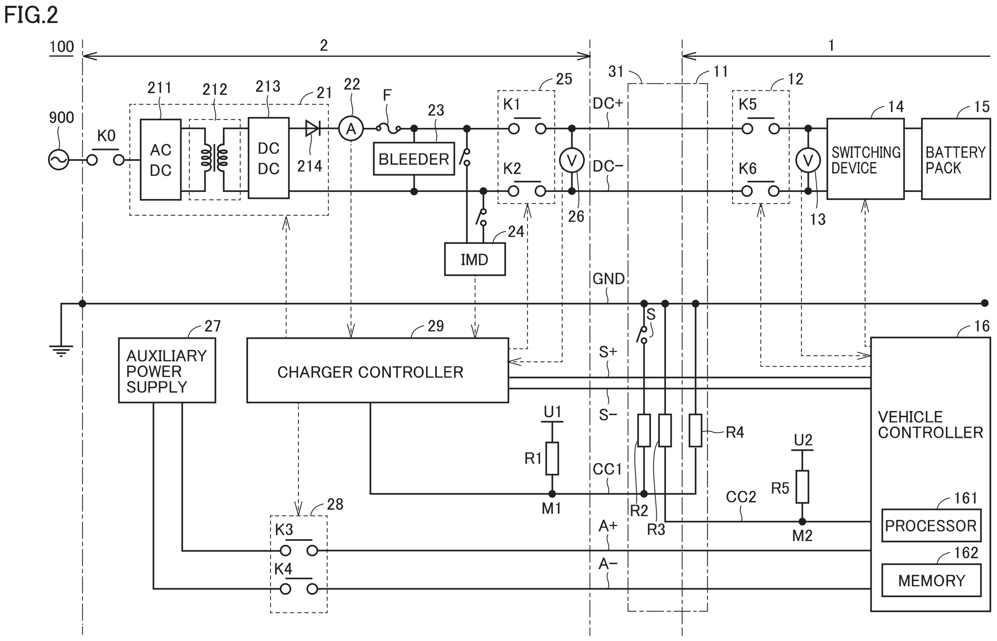

Fig. 2 is a circuit block diagram showing in detail an exemplary configuration of charging system 100. Charger 2 converts supplied power (alternating-current (AC) power) from a system power supply 900 (typically, a commercial power supply) to charging power (DC power) for vehicle 1 and feeds DC power to vehicle 1. Charger 2 includes a contactor K0, a power converter 21, a current sensor 22, a fuse F, a bleeder circuit 23, an insulation monitoring device (IMD) 24, an electromagnetic contactor circuit 25, a voltage sensor 26, an auxiliary power supply 27, an electromagnetic contactor circuit 28, a resistor R1, and a charger controller 29.

Contactor K0 is electrically connected between system power supply 900 and power converter 21. Contactor K0 switches between supply and cut-off of AC power from system power supply 900 under the control by charger controller 29.

Power converter 21 converts AC power from system power supply 900 to DC power for charging of a battery pack 15 (which will be described later) mounted on vehicle 1. Power converter 21 includes, for example, an AC/DC converter 211, a transformer 212, a DC/DC converter 213, and a diode 214. Power converter 21 outputs DC power to a power feed line DC+ and a power feed line DC-.

Current sensor 22 is electrically connected, for example, to power feed line DC+. Current sensor 22 detects a current that flows through power feed line DC+ and outputs a result of detection to charger controller 29. Fuse F is electrically connected, for example, to power feed line DC+. Bleeder circuit 23 is electrically connected between power feed line DC+ and power feed line DC-. Bleeder circuit 23 has a capacitor (not shown) discharge, the capacitor being provided on an output side of power converter 21.

IMD 24 is electrically connected between power feed line DC+ and power feed line DC-. IMD 24 conducts insulation diagnosis of charger 2. More specifically, IMD 24 applies an insulation diagnosis voltage Vdiag (details of which will be described later) across power feed line DC+ and power feed line DC- and measures an insulation resistance under that condition.

Electromagnetic contactor circuit 25 includes a contactor K1 connected to power feed line DC+ and a contactor K2 connected to power feed line DC-. Electromagnetic contactor circuit 25 switches between supply and cut-off of DC power from power converter 21 under the control by charger controller 29.

Voltage sensor 26 is electrically connected between power feed line DC+ and power feed line DC-. Voltage sensor 26 detects a voltage across power feed line DC+ and power feed line DC- and outputs a result of detection to charger controller 29.

Auxiliary power supply 27 supplies a low voltage for realizing communication between charger controller 29 and a vehicle controller 16 (which will be described later) of vehicle 1 to vehicle controller 16 through a lead A+ and a lead A-.

Electromagnetic contactor circuit 28 includes a contactor K3 connected to lead A+ and a contactor K4 connected to lead A-. Electromagnetic contactor circuit 28 switches between supply and cut-off of a low voltage from auxiliary power supply 27 under the control by charger controller 29.

Resistor R1 is connected between a circuit CC1 from charger controller 29 and a pull-up voltage U1.

Charger controller 29 includes a processor, a memory, and an input and output interface (none of which is shown). The processor controls an operation for power feed from charger 2 to vehicle 1 based on a current detected by current sensor 22, a voltage detected by voltage sensor 26, communication with vehicle 1, and a map, a program, and the like stored in the memory.

Vehicle plug 31 includes a resistor R2, a resistor R3, and a switch S. Resistor R2 and switch S are connected in series between circuit CC1 and a ground line GND. Resistor R3 is connected between a circuit CC2 from vehicle controller 16 and ground line GND.

Vehicle 1 includes vehicle socket 11, an electromagnetic contactor circuit 12, a voltage sensor 13, a switching device 14, battery pack 15, a resistor R5, and vehicle controller 16.

Vehicle socket 11 is configured such that vehicle plug 31 of charging cable 3 can be inserted therein with mechanical coupling such as fitting. Vehicle socket 11 includes a resistor R4. Resistor R4 is connected between circuit CC1 and ground line GND.

Electromagnetic contactor circuit 12 includes a contactor K5 connected to power feed line DC+ and a contactor K6 connected to power feed line DC-. Electromagnetic contactor circuit 12 switches between reception and cut-off of charging power supplied through vehicle socket 11 under the control by vehicle controller 16.

Voltage sensor 13 is electrically connected between power feed line DC+ and power feed line DC-. Voltage sensor 13 detects a charging voltage across power feed line DC+ and power feed line DC- and outputs a result of detection to vehicle controller 16. Voltage sensor 13 corresponds to the "voltage sensor" according to the present disclosure.

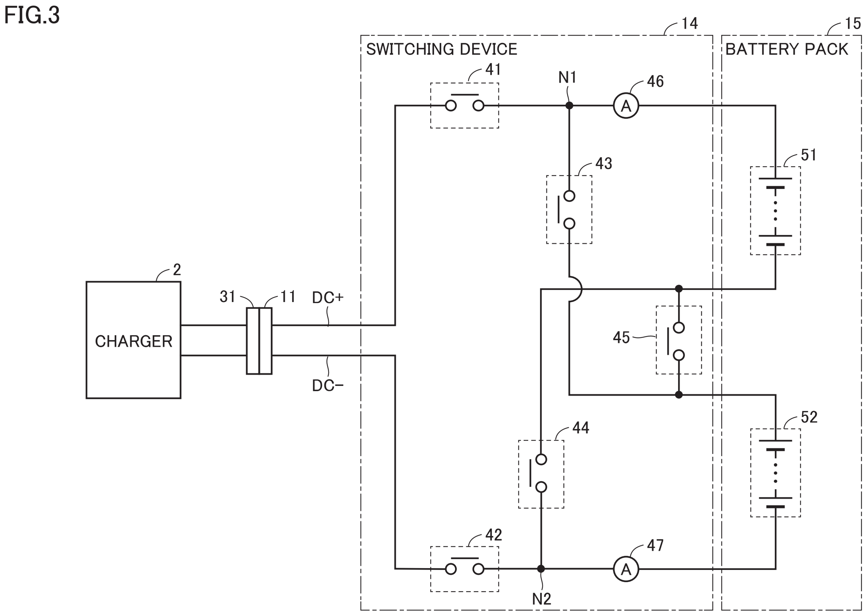

Switching device 14 is electrically connected between electromagnetic contactor circuit 12 and battery pack 15. Switching device 14 is configured to switch between charging schemes different from each other in charging voltage. The configuration of switching device 14 will be described with reference to Figs. 3 to 5.

Battery pack 15 is electrically connected to switching device 14. Battery pack 15 is a battery assembly including a plurality of battery modules. Each battery module includes a plurality of cells. Each cell is a secondary battery such as a lithium ion secondary battery or a nickel metal hydride battery. Each cell may be a solid-state battery. A configuration of battery pack 15 will be described with reference to Fig. 3. Battery pack 15 corresponds to the "power storage device" according to the present disclosure. The "power storage device" may be a capacitor such as an electric double layer capacitor.

Resistor R5 is connected between circuit CC2 and a pull-up voltage U2.

Vehicle controller 16 is a vehicle-mounted electronic control unit (ECU) and includes a processor 161, a memory 162, and an input and output interface (not shown). Processor 161 includes processing circuitry such as a central processing unit (CPU) or a micro processing unit (MPU). Memory 162 includes a volatile storage device such as a dynamic random access memory (DRAM) or a static random access memory (SRAM) and a non-volatile storage device (storage) such as a hard disk drive (HDD), a solid state drive (SSD), or a flash memory. A system program including an operating system (OS) and a program for control of an operation to charge vehicle 1 are stored in memory 162. Processor 161 realizes various types of processing by reading the system program and the program and developing and executing them on memory 162. Vehicle controller 16 corresponds to the "controller" according to the present disclosure.

Though Fig. 1 shows only a single processor, vehicle 1 may include a plurality of processors. The "processor" herein is not limited to a processor in a narrow sense that performs processing in accordance with a stored program architecture but may encompass hard-wired circuitry such as an application specific integrated circuit (ASIC) or a field-programmable gate array (FPGA). Therefore, the term "processor" can also be read as circuitry or processing circuitry, processing by which is defined in advance by a computer readable code and/or hard-wired circuitry.

### <Switching Between Charging Schemes>

Fig. 3 is a circuit block diagram showing in detail an exemplary configuration of switching device 14 and battery pack 15. Switching device 14 includes, for example, five contactors 41 to 45 and two current sensors 46 and 47. Battery pack 15 includes, for example, two battery modules 51 and 52. Battery module 51 and battery module 52 are modules equal to each other in voltage level (typically, modules including equal number of cells of the same type). A full charge voltage of each of battery modules 51 and 52 is, for example, 400 V.

Contactor 41 is electrically connected between vehicle socket 11 and a node N1, in power feed line DC+. Contactor 42 is electrically connected between vehicle socket 11 and a node N2, in power feed line DC-. Contactor 43 is electrically connected between node N1 and a positive electrode of battery module 52. Contactor 44 is electrically connected between node N2 and a negative electrode of battery module 51. Contactor 45 is electrically connected between the negative electrode of battery module 51 and the positive electrode of battery module 52. Each of contactors 41 to 45 is closed (turned on)/opened (turned off) under the control by vehicle controller 16.

Current sensor 46 is electrically connected between node N1 and a positive electrode of battery module 51. Current sensor 47 is electrically connected between node N2 and a negative electrode of battery module 52.

Switching device 14 and battery pack 15 are configured to switch between a high voltage scheme and an ultra-high voltage scheme. A charging voltage in the ultra-high voltage scheme is higher than a charging voltage in the high voltage scheme.

Fig. 4 is a diagram for illustrating control of switching device 14 for realizing the high voltage scheme. When fast charger 2B is connected to vehicle plug 31, vehicle controller 16 closes contactors 41 to 44 and opens contactor 45. Battery module 51 and battery module 52 are then connected in parallel. A state of battery pack 15 suitable for charging in the high voltage scheme is thus realized.

Fig. 5 is a diagram for illustrating control of switching device 14 for realizing the ultra-high voltage scheme. When ultra-fast charger 2A is connected to vehicle plug 31, vehicle controller 16 closes contactors 41, 42, and 45 and opens contactors 43 and 44. Battery module 51 and battery module 52 are then connected in series. A state of battery pack 15 suitable for charging in the ultra-high voltage scheme is thus realized.

The ultra-high voltage scheme corresponds to the "first scheme" according to the present disclosure. The high voltage scheme corresponds to the "second scheme" according to the present disclosure. For the sake of facilitated understanding, an example is described in which the charging voltage in the "first scheme" is two times as high as the charging voltage in the "second scheme," and in order to adapt thereto, connection between battery module 51 and battery module 52 is switched between connection in series and connection in parallel. The charging voltage in the "first scheme" and the charging voltage in the "second scheme," however are not limited as such. For example, in an example where there are more battery modules (three or more battery modules), connection relation among the battery modules is switched in a more complicated manner in order to adapt to relation in voltage (a voltage difference or a voltage ratio) between the "first scheme" and the "second scheme."

### <Communication Sequence>

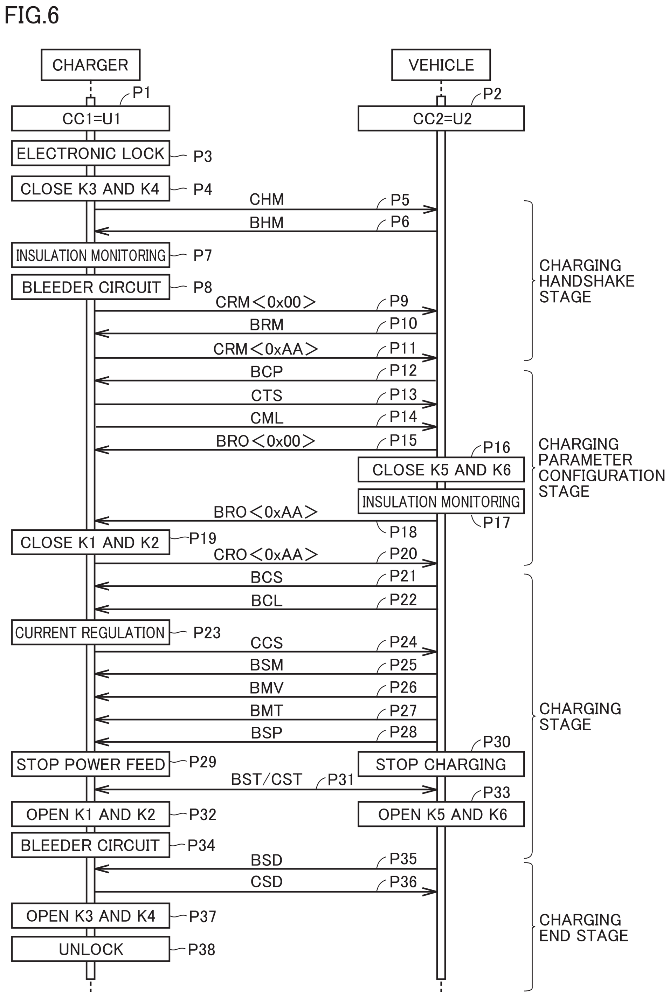

Fig. 6 is a sequence diagram showing an exemplary communication sequence in external charging. In the figure, a process performed by charger 2 (charger controller 29) is shown on the left and a process performed by vehicle 1 (vehicle controller 16) is shown on the right. This communication sequence is started when vehicle 1 and charger 2 are mechanically coupled to each other through charging cable 3 and furthermore, a low voltage for realizing communication between vehicle 1 and charger 2 is supplied. Each process (shown with P) is classified into a charging handshake stage, a charging parameter configuration stage, a charging stage, or a charging end stage.

Fig. 6 illustrates an example where a specific charging standard (specifically, GB/T18487.1) is assumed. For details of each message, for example, GB/T27930 may be referred to. A person skilled in the art could apply explanation below mutatis mutandis to various charging standards.

Referring to Figs. 2 and 6, when vehicle plug 31 of charging cable 3 is connected to vehicle socket 11 and switch S is turned on, a voltage of circuit CC1 in charger 2 attains to pull-up voltage U1 (for example, 4 V) (P1) and a voltage of circuit CC2 in vehicle 1 attains to pull-up voltage U2 (for example, 6 V) (P2). When charger controller 29 detects a voltage of circuit CC1 attaining to pull-up voltage U1, it applies an electronic lock (not shown) provided at a portion of connection between vehicle plug 31 and vehicle socket 11 (P3). Charger controller 29 then closes contactors K3 and K4 of electromagnetic contactor circuit 28 (P4).

### <<Charging Handshake Stage>>

In the charging handshake stage, a communication link between vehicle 1 (vehicle controller 16) and charger 2 (charger controller 29) is established. Specifically, charger controller 29 transmits a message CHM for checking handshake between vehicle 1 and charger 2 to vehicle controller 16 (P5).

When the voltage of circuit CC2 in vehicle 1 attains to pull-up voltage U2 and vehicle controller 16 receives message CHM from charger controller 29, vehicle controller 16 transmits a message BHM for confirming handshake to charger controller 29 (P6). Message BHM may include a highest allowable voltage Vmax which will be described later.

When charger controller 29 receives message BHM from vehicle controller 16, it conducts insulation diagnosis of charger 2 with IMD 24 (P7). When an insulated state of charger 2 is normal, charger controller 29 turns on bleeder circuit 23 and causes discharge of a voltage accumulated in power converter 21 along with insulation diagnosis (P8).

When discharge caused by bleeder circuit 23 ends, charger controller 29 transmits a message CRM <0x00> to vehicle controller 16 (P9). Message CRM is an identification message transmitted from charger controller 29 to vehicle controller 16 for confirming that the communication link between charger 2 and vehicle 1 is accurate. <0x00> is a prescribed parameter included in message CRM and indicates that charger controller 29 has not yet been able to identify vehicle 1.

When vehicle controller 16 receives message CRM <0x00> from charger controller 29, it transmits a message BRM to charger controller 29 (P10). Message BRM includes identification information of vehicle 1. Message BRM includes information, for example, on a version number of a communication protocol installed in vehicle 1, a type, a rated capacity, and a rated voltage of battery pack 15, and the like.

When charger controller 29 receives message BRM from vehicle controller 16, it transmits a message CRM <0xAA> to vehicle controller 16 (P11). <0xAA> is a parameter included in message CRM and indicates that charger controller 29 could identify vehicle 1. Handshake between vehicle 1 and charger 2 is thus completed and the process proceeds to the charging parameter configuration stage.

### <<Charging Parameter Configuration Stage>>

In the charging parameter configuration stage, such an operation as determination of a charging condition or confirmation as to whether or not preparation for charging has been made is performed. Specifically, when vehicle controller 16 receives message CRM <0xAA> from charger controller 29, it transmits a message BCP to charger controller 29 (P12). Message BCP is a message about a charging parameter (charging condition) for battery pack 15. Message BCP includes information, for example, on a highest allowable charging total voltage, a highest allowable charging current, a full charge capacity (rated total energy), a highest allowable temperature, a current state of charge (SOC) (a state of being charged), a current total voltage, and the like.

The highest allowable charging total voltage will be denoted as "highest allowable voltage Vmax" below. Highest allowable voltage Vmax refers to a voltage when the charging scheme is switched by switching device 14 to a scheme highest in charging voltage (the ultra-high voltage scheme in this example) and battery pack 15 is fully charged, and briefly refers to a highest voltage to which battery pack 15 can attain. Highest allowable voltage Vmax is a fixed value defined in advance in accordance with specifications (a full charge voltage of each cell, the number of cells connected in series, or the like) of battery pack 15.

When charger controller 29 receives message BCP from vehicle controller 16, it transmits a message CTS to vehicle controller 16 (P13). Message CTS is time information synchronized between vehicle 1 and charger 2. Furthermore, charger controller 29 transmits a message CML to vehicle controller 16 (P14). Message CML includes information on maximum output capability of charger 2. Message CML includes information, for example, on a maximum output voltage, a lowest output voltage, a maximum output current, a minimum output current of charger 2, and the like.

When vehicle controller 16 receives message CML from charger controller 29, it transmits a message BRO <0x00> to charger controller 29 (P15). Message BRO is a message indicating whether or not preparation for charging has been completed in vehicle 1. <0x00> is a prescribed parameter included in message BRO and indicates that preparation for charging has not yet been completed in vehicle 1.

When vehicle controller 16 transmits message BRO <0x00> to charger controller 29, it closes contactors K5 and K6 of electromagnetic contactor circuit 12 (P16). Furthermore, vehicle controller 16 conducts insulation diagnosis of vehicle 1 with the IMD (not shown in Fig. 2) provided in vehicle 1 (P17). When an insulated state of vehicle 1 is normal, vehicle controller 16 transmits message BRO <0xAA> to charger controller 29 (P18). <0xAA> is a parameter of message BRO and indicates completion of preparation for charging in vehicle 1.

When charger controller 29 receives message BRO <0xAA> from vehicle controller 16, it closes contactors K1 and K2 of electromagnetic contactor circuit 25 (P19). Furthermore, charger controller 29 transmits a message CRO <0xAA> to vehicle controller 16 (P20). Message CRO is a message indicating whether or not preparation for charging has been completed in charger 2. <0xAA> is a prescribed parameter included in message CRO and indicates completion of preparation for charging in charger 2. Power feed from charger 2 and charging of vehicle 1 are thus enabled and the process makes transition to the charging stage.

### <<Charging Stage>

In the charging stage, power converter 21 is driven in charger 2 and electric power is fed to vehicle 1, and battery pack 15 is charged in vehicle 1. Specifically, vehicle controller 16 transmits a message BCS and a message BCL to charger controller 29 (P21 and P22). Message BCS includes information, for example, on a charging voltage, a charging current, and an SOC of battery pack 15 as well as an estimated value of a remaining charging time period or the like. Message BCL includes information, for example, on a requested voltage and a requested current from vehicle 1 to charger 2 as well as a charging mode (a constant voltage charging mode or a constant current charging mode).

Charger controller 29 regulates the charging current by controlling power converter 21 as appropriate (P23). Charger controller 29 transmits a message CCS to vehicle controller 16 (S24). Message CCS is a message for a notification of start (continuation) of charging, and includes information, for example, on an output voltage and an output current of charger 2.

During charging of battery pack 15, vehicle controller 16 transmits a message BSM, a message BMV, a message BMT, and a message BSP to charger controller 29 (P25 to P28). Message BSM is a message indicating the SOC of battery pack 15. Message BMV is a message indicating the voltage of battery pack 15. Message BMT is a message indicating a temperature of battery pack 15. Message BSP is a preliminary message for notification of a state of battery pack 15 to charger controller 29.

Charger controller 29 then determines whether or not a condition for stopping power feed has been satisfied, and when it determines that the condition has been satisfied, it stops power feed from charger 2 to vehicle 1 (P29). Vehicle controller 16, on the other hand, determines whether or not the condition for stopping charging has been satisfied, and when it determines that the condition has been satisfied, it stops charging of vehicle 1 (P30). At this time, vehicle controller 16 transmits a message BST indicating abort by vehicle 1 of charging to charger controller 29 (P31). Message BST may include information on a cause or the like for abort by vehicle 1 of charging. In addition, charger controller 29 transmits a message CST indicating abort by charger 2 of power feed to vehicle controller 16. Message CST may include information on a cause or the like for abort by charger 2 of power feed.

Thereafter, charger controller 29 opens contactors K1 and K2 of electromagnetic contactor circuit 25 (P32). Vehicle controller 16 opens contactors K5 and K6 of electromagnetic contactor circuit 12 (P33). Furthermore, charger controller 29 turns on bleeder circuit 23 to cause discharge of the voltage accumulated in power converter 21 (P34). The charging stage thus ends and the process proceeds to the charging end stage.

### <<Charging End Stage>

In the charging end stage, statistical data on present charging is transmitted and received between vehicle 1 and charger 2. Specifically, vehicle controller 16 transmits a message BSD indicating the statistical data of vehicle 1 in the present charging process to charger controller 29 (P35). Charger controller 29, on the other hand, transmits a message CSD indicating the statistical data of charger 2 in the present charging process to vehicle controller 16 (P36).

Charger controller 29 then opens contactor K3 and K4 of electromagnetic contactor circuit 28 (P37). Finally, charger controller 29 unlocks the electronic lock at the portion of connection between vehicle plug 31 and vehicle socket 11 (P38). External charging defined in the communication protocol thus ends.

### <Maximum Output Capability of Charger>

In the communication protocol exemplified in Fig. 6, in message CML in the charging parameter configuration stage, the maximum output capability (in particular, the maximum output voltage) of charger 2 is transmitted from charger 2 to vehicle 1 (see P14). Vehicle 1 may determine the charging scheme thereof in accordance with the maximum output voltage of charger 2. Vehicle 1, however, may desirably determine the charging scheme before it receives message CML from charger 2. This is because, depending on charger 2, if vehicle 1 changes the charging scheme after transmission of message CML, the communication sequence shown in Fig. 6 may be terminated on the assumption that vehicle 1 has performed an abnormal operation and charger 2 may not feed power to vehicle 1.

In the present embodiment, vehicle controller 16 takes an opportunity of insulation diagnosis (see P7) conducted by charger controller 29 in the charging handshake stage before the charging parameter configuration stage to determine the charging scheme of vehicle 1. Change of the charging scheme of vehicle 1 after transmission of message CML from charger 2 to vehicle 1 is thus suppressed. Therefore, even when charger 2 is an apparatus not adapted to change of the charging scheme after transmission of message CML, vehicle 1 can more reliably be externally charged.

### <Process Flow>

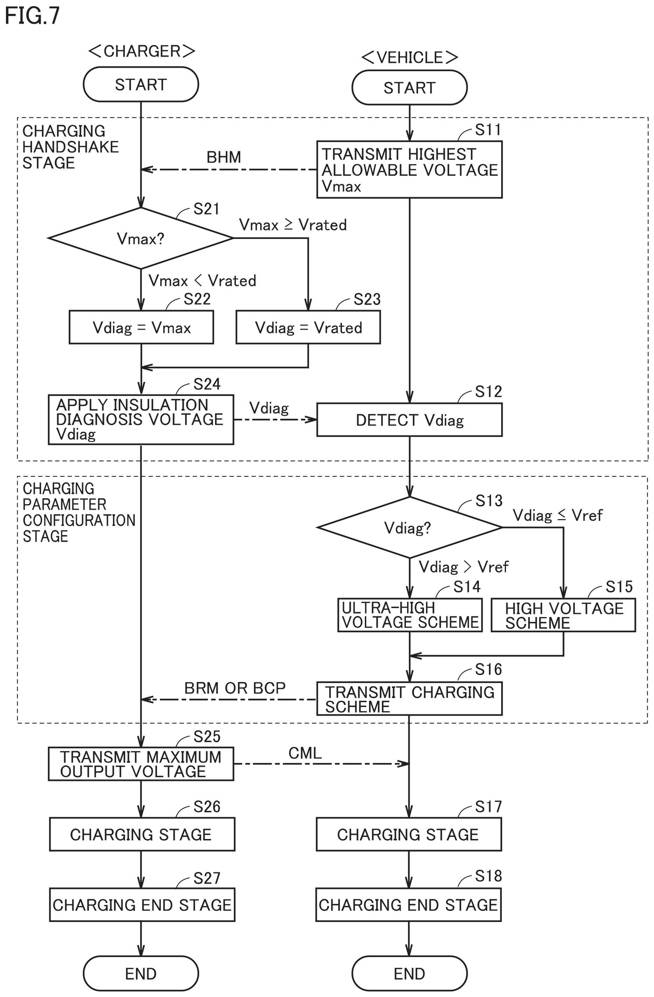

Fig. 7 is a flowchart for illustrating an exemplary processing procedure for determining the charging scheme in the present embodiment. Processing shown in this flowchart is performed when a predetermined condition is satisfied (for example, connection between vehicle 1 and charger 2 through charging cable 3 is detected). In the figure, a process by charger 2 (charger controller 29) is shown on the left and a process by vehicle 1 (vehicle controller 16) is shown on the right. Though each step is typically performed by software processing, it may be performed by hardware processing. A step will be abbreviated as S below.

Referring to Figs. 2 and 7, in S11, vehicle 1 transmits predetermined highest allowable voltage Vmax of vehicle 1 to charger 2 in the charging handshake stage. As described previously, highest allowable voltage Vmax is a highest voltage to which battery pack 15 can attain. In examples in Figs. 3 to 5, a voltage at the time when battery module 51 and battery module 52 are connected in series and both of battery modules 51 and 52 are fully charged is defined as highest allowable voltage Vmax. In an example where the full charge voltage of each of battery modules 51 and 52 is 400 V, highest allowable voltage Vmax is approximately 800 V. In the communication sequence described with reference to Fig. 6, vehicle 1 may transmit highest allowable voltage Vmax as being incorporated in message BHM for confirming handshake (see P6 in Fig. 6). The message corresponds to the "highest allowable voltage message" according to the present disclosure.

In S21 to S24, charger 2 conducts insulation diagnosis of charger 2 with IMD 24 (see P7 in Fig. 6). In insulation diagnosis, charger 2 sets insulation diagnosis voltage Vdiag in accordance with highest allowable voltage Vmax received from vehicle 1.

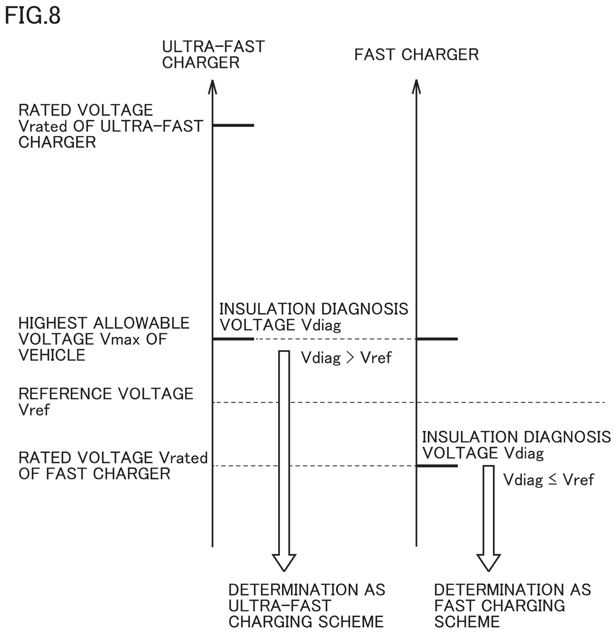

Fig. 8 is a conceptual diagram for illustrating insulation diagnosis in the present embodiment. Referring to Figs. 7 and 8, a rated voltage (a maximum voltage suppliable by charger 2) Vrated of charger 2 in an example where charger 2 is ultra-fast charger 2A is higher than a rated voltage of charger 2 in an example where charger 2 is fast charger 2B. In the stage of insulation diagnosis by charger 2, vehicle 1 has not known the rated voltage of charger 2, whereas charger 2 has already known rated voltage Vrated of the charger itself.

When charger 2 receives highest allowable voltage Vmax from vehicle 1 in S11, in S21, it compares highest allowable voltage Vmax with rated voltage Vrated and determines which voltage is lower (S21), because insulation diagnosis voltage Vdiag is set to lower one of rated voltage Vrated and highest allowable voltage Vmax.

Specifically, in the example where charger 2 is ultra-fast charger 2A, highest allowable voltage Vmax is lower than rated voltage Vrated (Vmax < Vrated in S21). Therefore, charger 2 sets insulation diagnosis voltage Vdiag to highest allowable voltage Vmax (S22). In contrast, in the example where charger 2 is fast charger 2B, rated voltage Vrated is equal to or lower than highest allowable voltage Vmax (Vrated ≤ Vmax in S21). Therefore, charger 2 sets insulation diagnosis voltage Vdiag to rated voltage Vrated (S23).

In S24, charger 2 applies insulation diagnosis voltage Vdiag set in S22 or S23 across power feed line DC+ and power feed line DC-. Charger 2 then measures the insulation resistance between power feed line DC+ and power feed line DC- at the time of application of insulation diagnosis voltage Vdiag.

While charger 2 is conducting insulation diagnosis, in S12, vehicle 1 obtains insulation diagnosis voltage Vdiag applied by charger 2 from voltage sensor 13. Vehicle 1 then compares insulation diagnosis voltage Vdiag with predetermined reference voltage Vref and determines which voltage is higher (S13). Reference voltage Vref is a positive fixed voltage except for 0 V. Reference voltage Vref is defined to be higher than the allowable voltage when battery pack 15 (at least one of battery modules 51 and 52 connected in parallel) is fully charged in the high voltage scheme and lower than the allowable voltage (that is, highest allowable voltage Vmax) when battery pack 15 (battery modules 51 and 52 connected in series) is fully charged in the ultra-high voltage scheme.

When insulation diagnosis voltage Vdiag is higher than reference voltage Vref (Vdiag > Vref in S13), charger 2 can be estimated as being highly likely ultra-fast charger 2A. Therefore, vehicle 1 determines the ultra-high voltage scheme (see Fig. 5) as the charging scheme of vehicle 1 (S14). When insulation diagnosis voltage Vdiag is equal to or lower than reference voltage Vref (Vdiag ≤ Vref in S13), on the other hand, charger 2 can be estimated as being highly likely fast charger 2B. Therefore, vehicle 1 determines the high voltage scheme (see Fig. 4) as the charging scheme of vehicle 1 (S15).

Though not shown, vehicle 1 may further control switching device 14 to adapt to the determined charging scheme (see Figs. 4 and 5). Timing to control switching device 14, however, is not limited as such. Switching device 14 is controlled at appropriate timing before start of the charging stage in S17 which will be described later, after the processing in S14 or S15.

In S16, vehicle 1 transmits the charging scheme determined in S14 or S15 to charger 2. In the communication protocol described with reference to Fig. 6, vehicle 1 may incorporate the charging scheme thereof in message BRM including the identification information of vehicle 1 (see P10 in Fig. 6). Alternatively, vehicle 1 may incorporate the charging scheme thereof in message BCP for notification of the charging parameter for battery pack 15 to charger 2 (see P12 in Fig. 6). These messages correspond to the "charging scheme message" according to the present disclosure.

In S25, charger 2 transmits the maximum output voltage thereof to vehicle 1. In the communication sequence described with reference to Fig. 6, the maximum output voltage is transmitted as a part of message CML including information on the maximum output capability of charger 2 (see P14).

Other processing in the charging handshake stage and the charging parameter configuration stage described in detail with reference to Fig. 6 is also performed. The processing has already been described in detail with reference to Fig. 6, and description will not be repeated for avoiding complication.

Thereafter, vehicle 1 and charger 2 perform processing in the charging stage (S17 and S26). Finally, vehicle 1 and charger 2 perform processing in the charging end stage (S18 and S27).

As set forth above, in the present embodiment, before vehicle controller 16 receives message CML indicating the maximum output voltage of charger 2 from charger controller 29, it takes an opportunity of insulation diagnosis by charger 2 to obtain insulation diagnosis voltage Vdiag of charger 2 with voltage sensor 13. Vehicle controller 16 then compares insulation diagnosis voltage Vdiag with predetermined reference voltage Vref. When insulation diagnosis voltage Vdiag is higher than reference voltage Vref, rated voltage Vrated of charger 2 can be estimated as being higher than highest allowable voltage Vmax (being an ultra-high voltage). In contrast, when insulation diagnosis voltage Vdiag is equal to or lower than reference voltage Vref, rated voltage Vrated of charger 2 can be estimated as being equal to or lower than highest allowable voltage Vmax (being a high voltage). Since rated voltage Vrated and the maximum output voltage strongly correlate with each other, the maximum output voltage is also the ultra-high voltage when rated voltage Vrated is the ultra-high voltage, and the maximum output voltage is also the high voltage when rated voltage Vrated is the high voltage. Therefore, vehicle controller 16 can determine the charging scheme of vehicle 1 based on rated voltage Vrated of charger 2 even when it has not obtained the maximum output voltage of charger 2. According to the present embodiment, the charging scheme of vehicle 1 can be determined before transmission of the maximum output voltage of charger 2 from charger 2 to vehicle 1.

### [Modification]

Transmission of a message indicating highest allowable voltage Vmax of vehicle 1 from vehicle controller 16 to charger controller 29 is described with reference to Fig. 7. In the present modification, accuracy in determination of the charging scheme of vehicle 1 is improved based on a way of setting highest allowable voltage Vmax. For facilitated understanding, description will be given initially with reference to a comparative example.

### <Setting of Highest Allowable Voltage>

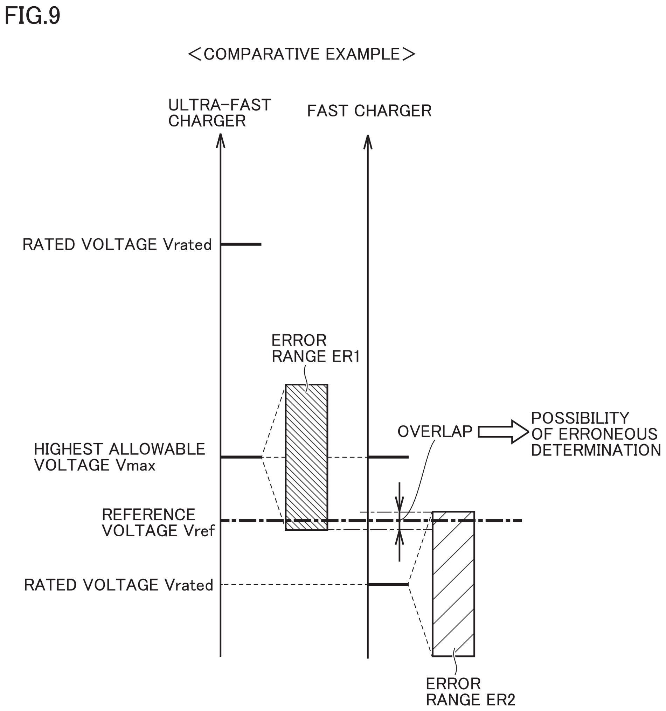

Fig. 9 is a diagram for illustrating a technique to set highest allowable voltage Vmax in the comparative example. As described previously, when highest allowable voltage Vmax is lower than rated voltage Vrated of charger 2 (in a case of the ultra-fast charger), insulation diagnosis voltage Vdiag is set to highest allowable voltage Vmax, whereas an output error of charger 2 may be produced in insulation diagnosis voltage Vdiag. In addition, a detection error may be produced also in voltage sensor 13 that detects insulation diagnosis voltage Vdiag. Therefore, there may be an error range ER1 shown with hatching in the figure in insulation diagnosis voltage Vdiag in the example where highest allowable voltage Vmax is lower than rated voltage Vrated. Error range ER1 may be called an error range of the allowable voltage in ultra-fast charging (first scheme).

In the example where rated voltage Vrated is lower than highest allowable voltage Vmax (in a case of the fast charger), on the other hand, insulation diagnosis voltage Vdiag is set to rated voltage Vrated. Similarly also at this time, in insulation diagnosis voltage Vdiag, an output error of charger 2 and a detection error of voltage sensor 13 may be produced. Therefore, there may be an error range ER2 shown with hatching also in insulation diagnosis voltage Vdiag in the example where rated voltage Vrated is lower than highest allowable voltage Vmax. Error range ER2 may be called an error range of the allowable voltage in fast charging (second scheme).

When a voltage difference between highest allowable voltage Vmax and rated voltage Vrated of the fast charger is assumed as being relatively small, a part of error range ER1 may overlap with a part of error range ER2. When reference voltage Vref is set in this overlapping area, in processing in S13 in Fig. 7, vehicle controller 16 may erroneously determine relation in magnitude between insulation diagnosis voltage Vdiag and reference voltage Vref. Then, vehicle controller 16 may be unable to correctly determine the charging scheme of vehicle 1.

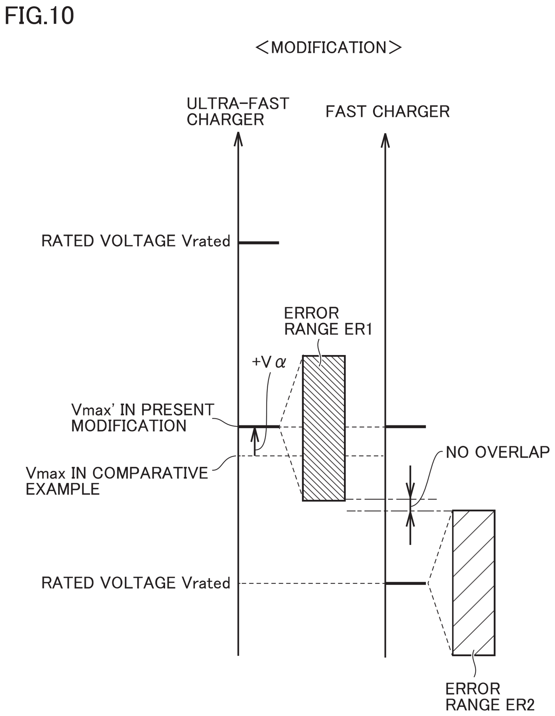

Fig. 10 is a diagram for illustrating a technique to set the highest allowable voltage in the present modification. In the present embodiment, vehicle controller 16 raises the highest allowable voltage by a prescribed voltage Vα from Vmax in the comparative example. In other words, vehicle controller 16 sets a highest allowable voltage Vmax' in the present modification to Vmax' = Vmax+Vα (Vα > 0). Vα is defined such that error range ER1 never overlaps with error range ER2, in consideration of the output error of charger 2 and the detection error of voltage sensor 13. In other words, highest allowable voltage Vmax is defined such that a lower limit voltage in error range ER1 of the highest allowable voltage is higher than an upper limit voltage in error range ER2 of rated voltage Vrated of the fast charger. Since reference voltage Vref is thus included in neither of error range ER1 and error range ER2, vehicle controller 16 can accurately determine relation in magnitude between insulation diagnosis voltage Vdiag and reference voltage Vref. Therefore, accuracy in determination of the charging scheme of vehicle 1 by vehicle controller 16 can be improved.

Description will be given with reference to one specific example. It is assumed that rated voltage Vrated of a fast charging facility is 400 V (the lower limit voltage in error range ER2 = 300 V and the upper limit voltage therein = 500 V) and that rated voltage Vrated of an ultra-fast charging facility is 800 V (the lower limit voltage in error range ER1 = 700 V and the upper limit voltage therein = 900V). In this case, highest allowable voltage Vmax is defined within a range from 500 V to 700 V, and preferably within a range, for example, from 610 V to 650 V. Reference voltage Vref may be set to 600 V.

In the embodiment and the modification described previously, one of two schemes (the ultra-high voltage scheme and the high voltage scheme) is described as being determined as the charging scheme. For example, there may be three charging schemes (three types of chargers 2) and vehicle 1 may adapt to the three charging schemes. In that case, one of the three charging schemes can be determined as the charging scheme by setting two reference voltages. Thus, according to the present embodiment, also in an example where vehicle 1 adapts to N (N being any natural number equal to or larger than three) schemes, an appropriate charging scheme compatible with charger 2 can be set by setting (N-1) reference voltages.

Though an embodiment of the present disclosure has been described, it should be understood that the embodiment disclosed herein is illustrative and non-restrictive in every respect. The scope of the present disclosure is defined by the terms of the claims and is intended to include any modifications within the scope and meaning equivalent to the terms of the claims.

## Claims

1. A vehicle (1) configured to externally be charged with DC power supplied from a charger (2) through a charging cable (3), the vehicle (1) comprising:
a power storage device (15) configured to be charged with charging power which is the DC power from the charger (2);
a voltage sensor (13) configured to detect a charging voltage of the charging power;
a switching device (14) configured to switch between charging schemes different in charging voltage; and
a controller (16) configured to determine a charging scheme, wherein
the controller (16) is configured to obtain from the voltage sensor (13), an insulation diagnosis voltage (Vdiag) applied by the charger (2) and to determine the charging scheme based on the insulation diagnosis voltage (Vdiag).

2. The vehicle (1) according to claim 1, wherein
the controller (16) is configured to transmit a highest allowable voltage message to the charger (2), the highest allowable voltage message indicating a highest allowable voltage (Vmax) of the vehicle (1), and
the highest allowable voltage (Vmax) is a voltage when the charging scheme is switched by the switching device (14) to a scheme highest in charging voltage and the power storage device (15) is fully charged.

3. The vehicle (1) according to claim 2, wherein
the controller (16) is configured to transmit a charging scheme message to the charger (2), the charging scheme message indicating the charging scheme determined based on the insulation diagnosis voltage (Vdiag).

4. The vehicle (1) according to claim 3, wherein
the vehicle (1) complies with a charging standard GB/T18487,
the highest allowable voltage message is a message BHM, and
the charging scheme message is a message BRM or a message BCP.

5. The vehicle (1) according to any one of claims 2 to 4, wherein
the charging scheme includes a first scheme and a second scheme lower in charging voltage than the first scheme, and
the controller (16) is configured to
determine the first scheme as the charging scheme when the insulation diagnosis voltage (Vdiag) is higher than a predetermined reference voltage (Vref), and
determine the second scheme as the charging scheme when the insulation diagnosis voltage (Vdiag) is lower than the reference voltage (Vref).

6. The vehicle (1) according to claim 5, wherein
the reference voltage (Vref) is a fixed voltage defined to be lower than the highest allowable voltage (Vmax).

7. The vehicle (1) according to claim 6, wherein
a lower limit voltage in an error range of the highest allowable voltage (Vmax) is defined to be higher than an upper limit voltage in an error range of an allowable voltage in the second scheme, and
the reference voltage (Vref) is defined to be intermediate between the lower limit voltage and the upper limit voltage.

8. A charging system comprising:
a charger (2); and
a vehicle (1) according to any of claims 1 to 7, wherein
the charger (2) is configured to conduct insulation diagnosis of the charger (2) when the vehicle (1) and the charger (2) are connected to each other through the charging cable (3), and after the charger (2) conducts the insulation diagnosis, the charger (2) is configured to transmit a first message to the controller (16), the first message indicating a maximum output voltage of the charger (2), and
the controller (16) is configured to obtain from the voltage sensor (13), an insulation diagnosis voltage (Vdiag) applied by the charger (2) while the charger conducts the insulation diagnosis and to determine the charging scheme based on the insulation diagnosis voltage (Vdiag).

9. The charging system according to claim 8, wherein
the controller (16) is configured to transmit a second message indicating a highest allowable voltage (Vmax) of the vehicle (1) to the charger (2) before the charger (2) conducts the insulation diagnosis,
the highest allowable voltage (Vmax) is a voltage when the charging scheme is switched by the switching device (14) to a scheme highest in charging voltage and the power storage device (15) is fully charged, and
the charger (2) is configured to apply a voltage which is lower one of the highest allowable voltage (Vmax) and a rated voltage of the charger (2), as the insulation diagnosis voltage (Vdiag).

10. The charging system according to claim 9, wherein
the controller (16) is configured to transmit to the charger (2), a third message indicating the charging scheme determined based on the insulation diagnosis voltage (Vdiag), before the controller receives the first message.

11. The charging system according to claim 10, wherein
the vehicle (1) and the charger (2) comply with a charging standard GB/T18487,
the first message is a message CML,
the second message is a message BHM, and
the third message is a message BRM or a message BCP.

12. A method of charging a vehicle (1), the method being a method of externally charging the vehicle (1) with charging power which is DC power supplied from a charger (2) through a charging cable (3), the vehicle (1) being configured to switch between charging schemes different in charging voltage of the charging power, the method comprising:
conducting, by the charger (2), insulation diagnosis of the charger (2) when the vehicle (1) and the charger (2) are connected to each other through the charging cable (3);
obtaining, by the vehicle (1), an insulation diagnosis voltage (Vdiag) applied by the charger (2) with a voltage sensor (13) in the conducting insulation diagnosis;
determining, by the vehicle (1), a charging scheme based on the insulation diagnosis voltage (Vdiag); and
transmitting a message indicating a maximum output voltage of the charger (2) from the charger (2) to the vehicle (1) after the determining the charging scheme.
